(19) **Europäisches Patentamt European Patent Office Office européen des brevets**

(11) **EP 4 033 517 B1**

(12) **FASCICULE DE BREVET EUROPEEN**

(45) Date de publication et mention de la délivrance du brevet:
**10.12.2025 Bulletin 2025/50**

(21) Numéro de dépôt: **22153163.5**

(22) Date de dépôt: **25.01.2022**

(51) Classification Internationale des Brevets (IPC):
**H10D 84/03** *(2025.01)*

(52) Classification Coopérative des Brevets (CPC):
**H01L 21/02002; H10D 84/0128; H10D 84/038; H10D 84/83138;** H10D 84/0142

(54) **PROCÉDÉ DE RÉALISATION DE ZONES À BASE DE SIGE À DIFFÉRENTES CONCENTRATIONS EN GE**

VERFAHREN ZUR HERSTELLUNG VON ZONEN AUF SIGE-BASIS MIT UNTERSCHIEDLICHEN GE-KONZENTRATIONEN

METHOD FOR MANUFACTURING AREAS MADE WITH DIFFERENT GE CONCENTRATIONS OF SIGE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.01.2021 FR 2100699**

(43) Date de publication de la demande:
**27.07.2022 Bulletin 2022/30**

(73) Titulaire: **Commissariat à l'Energie Atomique et aux Energies Alternatives 75015 Paris (FR)**

(72) Inventeurs:
- **KANYANDEKWE, Joël
  38054 GRENOBLE Cedex 09 (FR)**
- **LE ROYER, Cyrille
  38054 GRENOBLE Cedex 09 (FR)**

(74) Mandataire: **Hautier IP
20, rue de la Liberté
06000 Nice (FR)**

(56) Documents cités:
**EP-A1- 3 503 175     EP-A1- 3 671 826
JP-B2- 5 079 511      US-A1- 2015 311 286**

# Description

## DOMAINE TECHNIQUE

La présente invention concerne le domaine de la microélectronique. Elle peut être mise en oeuvre pour co-intégrer différentes zones à base de SiGe à différentes concentrations en Ge sur un même substrat. Elle trouve pour application particulièrement avantageuse la réalisation de transistors co-intégrés présentant différentes longueurs de grille pour une tension de seuil sensiblement identique.

## ETAT DE LA TECHNIQUE

En technologie CMOS, i.e. basée sur des transistors métal-oxyde-semiconducteur complémentaires, les performances des transistors de type p peuvent être améliorées par l'utilisation de canaux à base de silicium-germanium SiGe, notamment à partir de substrats de type couche mince sur isolant complètement déplétée, par exemple en silicium complètement déplété sur isolant FDSOI (acronyme de Fully Depleted Silicon On Insulator).

La réalisation de canaux SiGe peut se faire localement par une technique dite d'enrichissement de germanium illustrée aux figures 1à 5.

À partir d'un substrat SOI ou FDSOI (figure 1), un masque dur 14 par exemple en nitrure de silicium est formé de façon à définir une zone d'enrichissement 2 (figure 2). Après désoxydation de l'oxyde natif 13 en surface du topSi 12 dans la zone d'enrichissement 2, une couche à base de Ge 20 est formée par épitaxie sur la portion de topSi exposée dans cette zone d'enrichissement 2 (figure 3). L'enrichissement en Ge, i.e. la diffusion du Ge depuis la couche à base de Ge 20 vers la portion de topSi, se fait ensuite par recuit thermique sous atmosphère oxydante (figure 4). Une portion 21 à base de SiGe est ainsi formée au sein du topSi 12. Le masque dur 14 et la couche d'oxyde résiduelle 22 sont ensuite retirés de façon à exposer le topSi 12 et la portion 21 à base de SiGe (figure 5).

Cette portion 21 à base de SiGe forme typiquement une zone active sur laquelle des grilles de transistors peuvent être formées. Des tranchées d'isolation STI sont alors gravées pour isoler les transistors entre eux.

Un premier inconvénient est que la ou les portions 21 à base de SiGe ainsi obtenues à l'issue de ce procédé présentent toutes la même concentration de Ge. Un deuxième inconvénient de cette solution est que la contrainte compressive engendrée initialement par la condensation du Ge est partiellement perdue lors de la gravure des STI. Cela diminue la mobilité des trous et donc les performances des transistors de type p. Cela est d'autant plus critique lorsque la zone active est de faible longueur, typiquement pour une dimension en longueur inférieure à environ 1μm.

Une solution pour compenser cette perte de contrainte compressive consiste à réintroduire des éléments compressifs au sein de la portion à base de SiGe. Le document US 2014/0349460 A1 divulgue par exemple un enrichissement local en Ge de la portion à base de SiGe, entre les empilements de grille, basé sur le même principe d'enrichissement de Ge. La mise en œuvre du module d'enrichissement en Ge à plusieurs reprises peut permettre d'obtenir différentes portions ou zones à base de SiGe présentant des concentrations en Ge différentes. Le document EP3503175A1 décrit une zone d'un dispositif dans laquelle une zone de SiGe est enrichie en Ge.

Cette solution a pour inconvénient de dégrader la qualité de l'interface entre l'empilement de grille et la portion SiGe.

Il existe donc un besoin consistant à limiter, voire à résoudre, les problématiques des solutions connues.

En particulier, un objet de la présente invention est de proposer un procédé de réalisation de zones à base de SiGe présentant des concentrations de Ge différentes, et un état de contrainte et/ou un état d'interface améliorés.

## RESUME

Pour atteindre cet objectif, selon un mode de réalisation on prévoit un procédé de formation d'au moins deux zones à base de SiGe dans une couche à base de silicium, comprenant les étapes suivantes :

- Fournir un substrat comprenant ladite couche à base de silicium,
- Définir au moins une première zone d'enrichissement en exposant une première portion de la couche à base de silicium,
- Former par épitaxie une première couche à base de Ge présentant une concentration initiale de Ge $[Ge]0$ sur la première portion, au niveau de ladite première zone d'enrichissement,
- Faire diffuser lors d'une première diffusion par recuit oxydant, selon au moins une première direction dite verticale, perpendiculaire à la première couche à base de Ge, le germanium de la première couche à base de Ge dans la première portion correspondant à la première zone d'enrichissement, ladite première portion devenant alors une première portion à base de SiGe présentant une première concentration de Ge $[Ge]1$, et la première couche à base de Ge devenant alors une première couche d'oxyde.

Avantageusement, le procédé comprend en outre les étapes suivantes:

- Définir au moins une deuxième zone d'enrichissement où la couche à base de silicium est exposée, ladite au moins une deuxième zone d'enrichissement étant distincte de la première zone d'enrichissement,

- Former un réseau de motifs de masquage sur la couche à base de silicium exposée au sein de l'au moins une deuxième zone d'enrichissement, de façon à définir une pluralité de portions transitoires de la couche à base de silicium,
- Former par épitaxie une deuxième couche à base de Ge présentant la concentration initiale de Ge [Ge]0 sur les portions transitoires de la couche à base de silicium, au niveau de ladite deuxième zone d'enrichissement,
- Faire diffuser par recuit oxydant, de préférence lors de la première diffusion, au moins selon la direction verticale, le germanium de la deuxième couche à base de Ge dans lesdites portions transitoires, de sorte que celles-ci deviennent des portions transitoires à base de SiGe présentant chacune la première concentration de Ge [Ge]1,
- Après diffusion du germanium par recuit oxydant selon la direction verticale, faire diffuser lors d'une deuxième diffusion, selon au moins une deuxième direction dite latérale, parallèle à la couche à base de silicium, le germanium desdites portions transitoires à base de SiGe au sein de la couche à base de silicium, sous le réseau de motifs de masquage, de façon à former au moins une deuxième portion à base de SiGe présentant une deuxième concentration de Ge [Ge]2 inférieure à [Ge]1, au niveau de la deuxième zone d'enrichissement.

Ainsi, la deuxième diffusion et le réseau de motifs de masquage permettent d'homogénéiser et de diminuer la concentration de Ge au niveau de la deuxième zone d'enrichissement. Cela permet de former une deuxième portion à base de SiGe présentant une concentration en Ge différente de celle de la première portion à base de SiGe. Le procédé permet avantageusement de co-intégrer plusieurs portions à base de SiGe présentant des concentrations en Ge différentes, sans recourir à plusieurs modules d'enrichissement successifs.

Une solution alternative, qui diffère de la solution revendiquée mais qui aurait pu être envisagée dans le cadre du développement de la présente invention aurait consisté à répéter localement le même procédé d'enrichissement du Ge à plusieurs reprises sur certaines zones d'intérêt de manière à augmenter la concentration en Ge dans ces zones d'intérêt.

Cette solution alternative n'a pas été retenue dans le cadre de la présente invention car il a été identifié que la répétition successive du module d'enrichissement est lourde à mettre en place, donc techniquement et économiquement inintéressante.

Au contraire, la présente invention vise à diminuer la concentration de Ge de certaines zones d'intérêt. Le réseau de motifs de masquage permet notamment d'éviter que le Ge issu de la deuxième couche à base de Ge ne diffuse dans la couche à base de silicium selon la direction verticale, sous et à l'aplomb des motifs de masquage, typiquement lors de la première diffusion. Des parties de la couche à base de silicium sont ainsi conservées, sous le réseau de motifs de masquage, de façon complémentaire aux portions transitoires à base de SiGe formées lors de la diffusion verticale. La deuxième diffusion qui se fait principalement latéralement et qui succède à la diffusion verticale, permet dès lors de transformer l'ensemble des parties à base de Si et des portions transitoires à base de SiGe en une seule et unique deuxième portion à base de SiGe présentant une deuxième concentration en Ge [Ge]2 sensiblement uniforme. Lors de cette deuxième diffusion, les portions transitoires à base de SiGe s'appauvrissent en Ge au profit des parties à base de Si qui s'enrichissent en Ge. Cette deuxième portion à base de SiGe présente donc une concentration en Ge [Ge]2 inférieure à [Ge]1.

Le procédé permet donc de former plusieurs portions à base de SiGe présentant différentes concentrations en Ge à partir d'un seul module d'enrichissement modifié.

Selon un exemple d'application avantageux, le procédé permet de former un dispositif comprenant une couche à base de silicium comprenant au moins une première portion à base de SiGe présentant une première concentration de Ge [Ge]1, et au moins une deuxième portion à base de SiGe présentant une deuxième concentration de Ge [Ge]2 inférieure à [Ge]1, et des première et deuxième grilles respectivement sur les première et deuxième portions à base de SiGe, lesdites première et deuxième grilles présentant respectivement des première et deuxième longueurs de grille Lg1 et Lg2, les première et deuxième concentrations de Ge [Ge]1 et [Ge]2 et les longueurs de grille Lg1 et Lg2 étant telles que les première et deuxième grilles présentent une tension de seuil sensiblement identique.

Il est entendu que les première et deuxième grilles désignées dans cet exemple particulier peuvent correspondre plus largement à des motifs de masquage à base d'un matériau différent du matériau des motifs de masquage utilisés dans la deuxième zone d'enrichissement. Ainsi les motifs de masquage utilisés dans la deuxième zone d'enrichissement peuvent être nommés premiers motifs de masquage ou encore "Mask_x", et les motifs de masquage utilisés sur les première et deuxième portions à base de SiGe peuvent être nommés deuxièmes motifs de masquage ou encore "Mask_y". Dans le cas d'un dispositif MOS ces motifs de masquage "Mask_y" sont typiquement des grilles.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

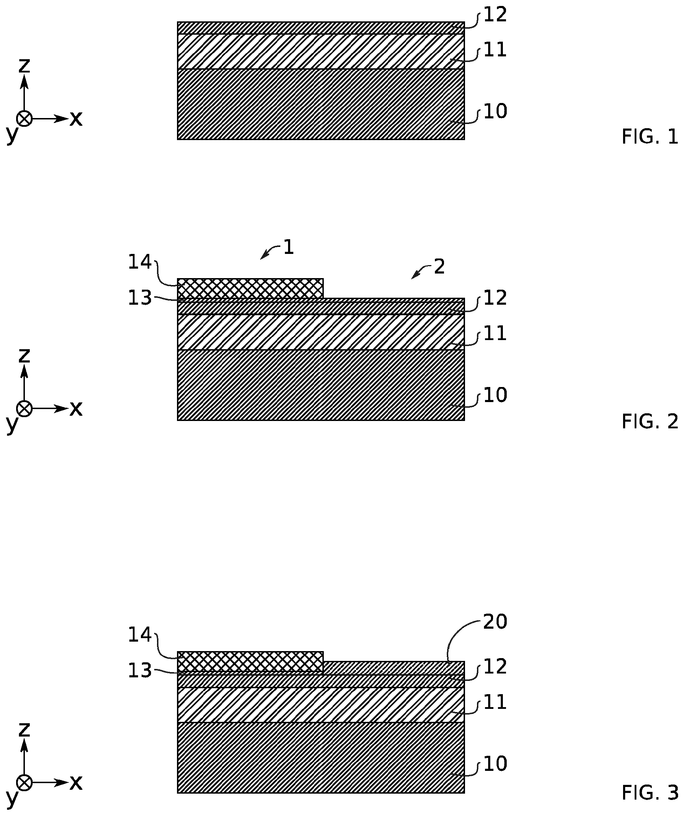

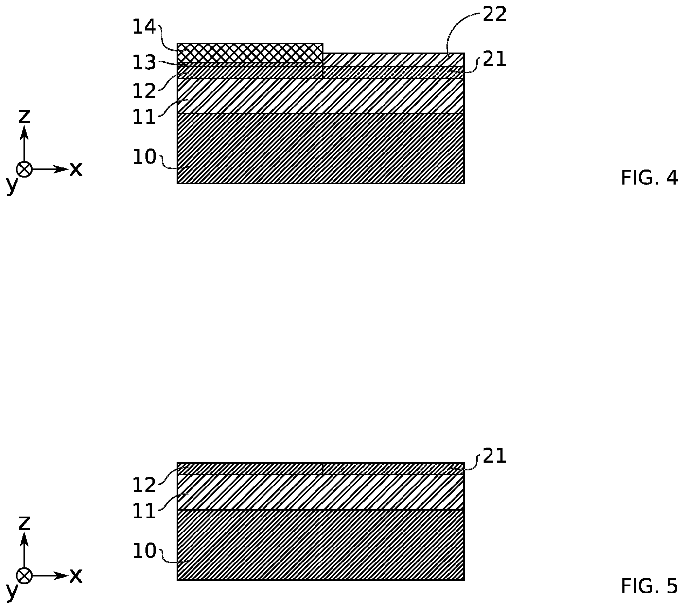

Les figures 1 à 5 illustrent schématiquement un procédé de formation d'une zone à base de SiGe selon l'art antérieur.

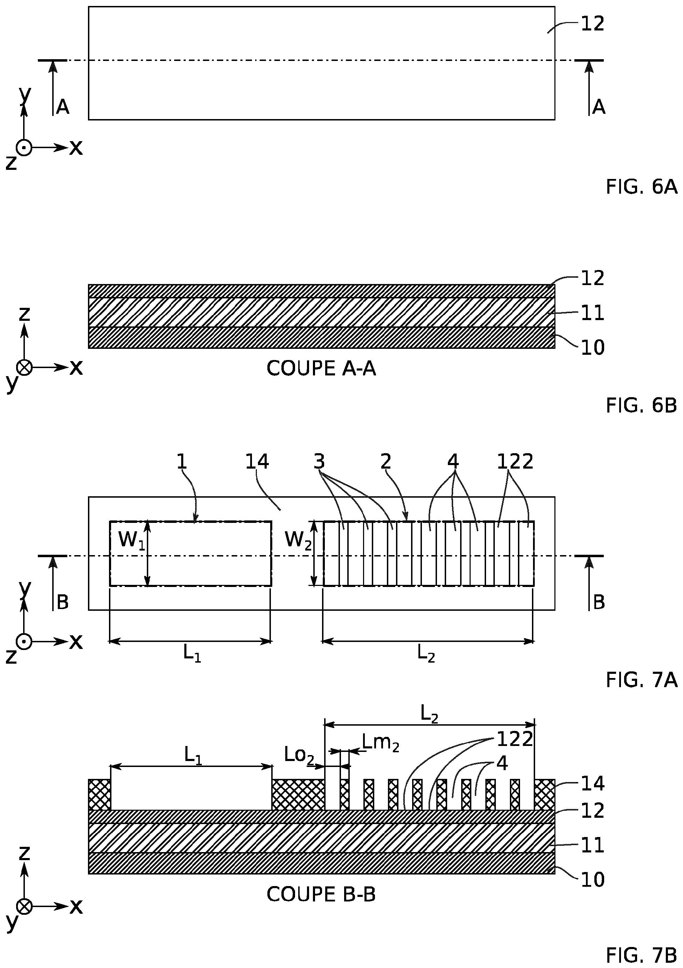

La figure 6A illustre schématiquement en vue de dessus une étape d'un procédé de formation de zones à base de SiGe, selon un mode de réalisation de la présente invention.

La figure 6B illustre schématiquement en coupe l'étape du procédé de formation de zones à base de SiGe illustré à la figure 6A.

La figure 7A illustre schématiquement en vue de dessus une étape d'un procédé de formation de zones à base de SiGe, selon un mode de réalisation de la présente invention.

La figure 7B illustre schématiquement en coupe l'étape du procédé de formation de zones à base de SiGe illustré à la figure 7A.

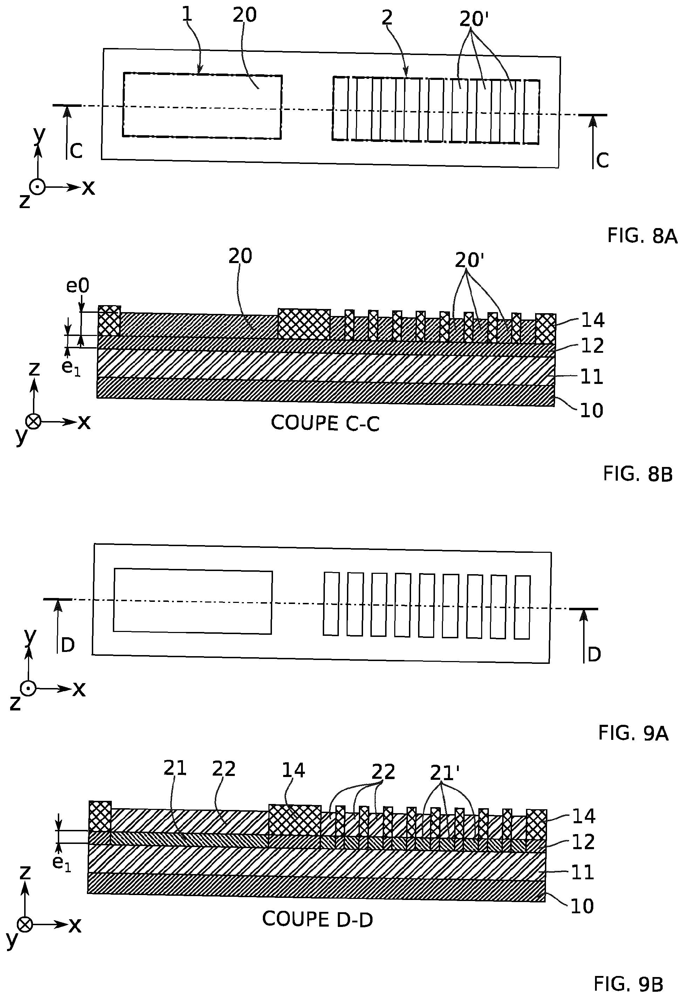

La figure 8A illustre schématiquement en vue de dessus une étape d'un procédé de formation de zones à base de SiGe, selon un mode de réalisation de la présente invention.

La figure 8B illustre schématiquement en coupe l'étape du procédé de formation de zones à base de SiGe illustré à la figure 8A.

La figure 9A illustre schématiquement en vue de dessus une étape d'un procédé de formation de zones à base de SiGe, selon un mode de réalisation de la présente invention.

La figure 9B illustre schématiquement en coupe l'étape du procédé de formation de zones à base de SiGe illustré à la figure 9A.

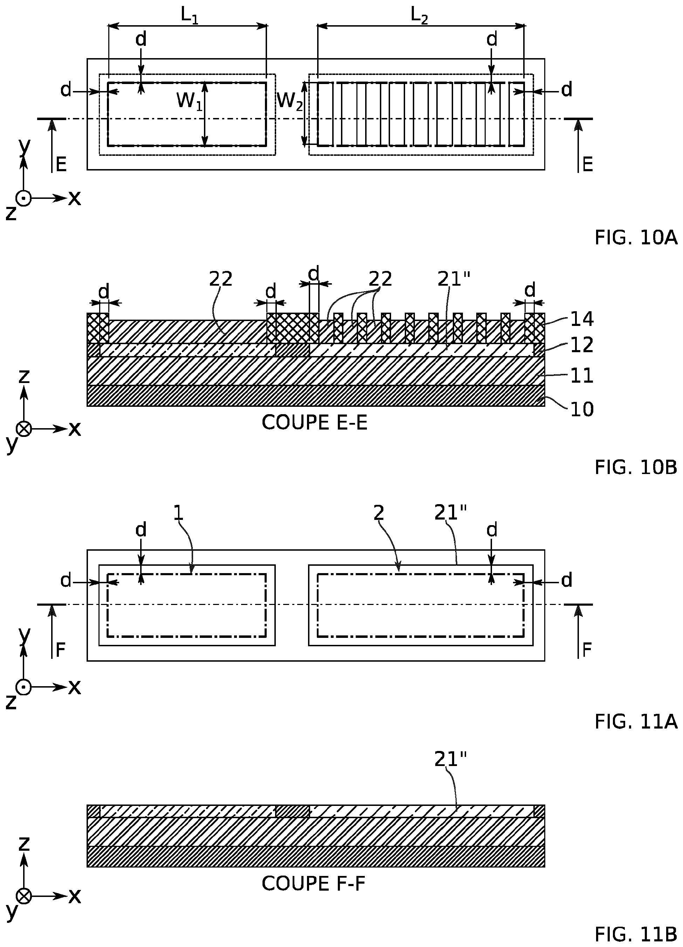

La figure 10A illustre schématiquement en vue de dessus une étape d'un procédé de formation de zones à base de SiGe, selon un mode de réalisation de la présente invention.

La figure 10B illustre schématiquement en coupe l'étape du procédé de formation de zones à base de SiGe illustré à la figure 10A.

La figure 11A illustre schématiquement en vue de dessus une étape d'un procédé de formation de zones à base de SiGe, selon un mode de réalisation de la présente invention.

La figure 11B illustre schématiquement en coupe l'étape du procédé de formation de zones à base de SiGe illustré à la figure 11A.

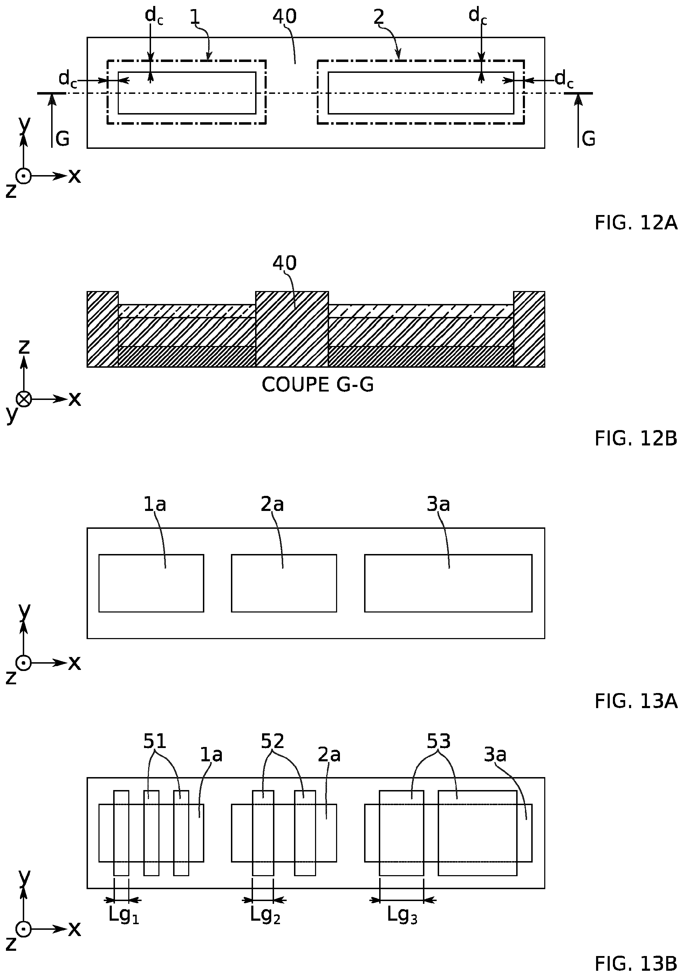

La figure 12A illustre schématiquement en vue de dessus une étape d'un procédé de formation de zones à base de SiGe, selon un mode de réalisation de la présente invention.

La figure 12B illustre schématiquement en coupe l'étape du procédé de formation de zones à base de SiGe illustré à la figure 12A.

La figure 13A illustre schématiquement en vue de dessus une étape d'un procédé de formation de zones à base de SiGe, selon un autre mode de réalisation de la présente invention.

La figure 13B illustre schématiquement en vue de dessus une étape d'un procédé de formation de zones à base de SiGe, selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, vias, motifs et reliefs ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement : Selon un exemple, les portions transitoires sont définies entre les motifs de masquage, en projection selon la première direction. Selon un exemple, la première zone d'enrichissement est exempte de motifs de masquage.

Selon un exemple, les première et deuxième portions à base de SiGe sont formées simultanément.

Selon un exemple, le réseau de motifs de masquage est formé de sorte à présenter une densité d'ouverture D strictement comprise entre 0 et 1, $0 < D < 1$, et la deuxième concentration de Ge [Ge]2 est proportionnelle à cette densité d'ouverture telle que $[Ge]2 = D. [Ge]1$.

Selon un exemple, la deuxième zone d'enrichissement présente une densité d'ouverture strictement inférieure à la densité d'ouverture de la première zone d'enrichissement. La première zone d'enrichissement est typiquement dépourvue de motifs de masquage, contrairement à la deuxième zone d'enrichissement.

Selon un exemple, les première et deuxième zones d'enrichissement présentent une même surface S, et la surface de la première portion de la couche à base de silicium exposée au niveau de la première zone d'enrichissement présente ladite surface S, tandis que les portions transitoires de la couche à base de silicium exposées au niveau de la deuxième zone d'enrichissement présente une surface totale S' strictement inférieure à S.

Selon un exemple, le réseau de motifs de masquage comprend des motifs de masquage présentant une dimension caractéristique de masquage Lmi espacés les uns des autres par un pas de réseau $Lo_i$, tels que $10 > Lo_i/Lm_i > 2$.

Selon un exemple, la dimension caractéristique de masquage $Lm_i$ est choisie inférieure à deux fois une distance de diffusion d du germanium au sein de la couche à base de silicium selon la deuxième direction, lors de la deuxième diffusion.

Selon un exemple, les motifs de masquage se présentent sous forme de lignes parallèles entre elles, ou de plots carrés ou rectangulaires ou de grille.

Selon un exemple, les première et deuxième couches à base de Ge sont formées par une seule et même épitaxie, de sorte que les première et deuxième couches à base de Ge présentent la même concentration initiale de Ge [Ge]0 et une même épaisseur.

Selon un exemple, la deuxième diffusion se fait sous atmosphère neutre ou non oxydante.

Selon un exemple, la deuxième diffusion est paramétrée en temps et en température de sorte qu'une distance de diffusion d du germanium selon la deuxième direction soit supérieure à 10 nm et/ou inférieure à 30 nm.

Selon un exemple, la deuxième diffusion est effectuée à une température T2 supérieure à 950°C et/ou inférieure à 1150°C.

Selon un exemple, la deuxième diffusion est effectuée pendant un temps t2 supérieur à 5s et/ou inférieur à 60s.

Selon un exemple, la deuxième diffusion est effectuée dans des conditions similaires à celles de la première diffusion, de sorte que la deuxième diffusion forme un prolongement de la première diffusion.

Selon un exemple, le procédé comprend en outre la formation de première et deuxième grilles respectivement sur les première et deuxième portions à base de SiGe, lesdites première et deuxième grilles présentant respectivement des première et deuxième longueurs de grille Lg1 et Lg2, les première et deuxième concentrations de Ge [Ge]1 et [Ge]2 et les longueurs de grille Lg1 et Lg2 étant telles que les première et deuxième grilles présentent une tension de seuil sensiblement identique.

Dans la présente demande, on entend par « diffusion » un phénomène de diffusion à l'état solide. Une diffusion effectuée selon la direction z signifie que cette diffusion se fait au moins selon z, de préférence principalement selon z. Cela ne signifie pas que la diffusion verticale se fait uniquement selon z. De même, une diffusion effectuée latéralement, selon une direction x, signifie que cette diffusion se fait au moins selon x, de préférence principalement selon x. Cela ne signifie pas que la diffusion latérale se fait uniquement selon x.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un film, une couche, « à base » d'un matériau A, un substrat, un film, une couche comprenant ce matériau A uniquement ou ce matériau A et éventuellement d'autres matériaux, par exemple des éléments d'alliage et/ou des éléments dopants. Ainsi, une couche à base de silicium peut signifier une couche en Si, une couche en Si dopée, une couche en alliage SiGe. Une couche à base de germanium peut signifier une couche en Ge, une couche en Ge dopée, une couche en alliage SiGe.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes. En outre, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par une tension de seuil Vth « sensiblement identique ou sensiblement constante », une tension de seuil Vth définie selon une certaine spécification, par exemple entre -0,1V et -0,15V.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Les termes « latéral », « latéralement » se réfèrent à une direction dans le plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans la présente demande de brevet, les concentrations sont exprimées en %at.

Un objectif de l'invention consiste à co-intégrer des zones de SiGe de mêmes épaisseurs présentant des concentrations différentes [Ge]1, [Ge]2, [Ge]3, ... sans recourir à plusieurs modules d'enrichissement successifs. Selon un principe de l'invention, différents réseaux de motifs de masquage sont utilisés dans les zones d'enrichissement, et une diffusion latérale est effectuée pour former des portions à base de SiGe de concentration uniforme dans lesdites zones d'enrichissement.

Le procédé d'enrichissement en germanium est parfois également appelé procédé de condensation du germanium dans la littérature.

Un exemple de mise en œuvre du procédé est illustré aux figures 6A à 11B. Dans cet exemple, pour une valeur de X donnée (X= 6...11), la figure XA est un schéma en vue de dessus du dispositif en cours de fabrication et la figure XB est le schéma en coupe correspondant.

Selon un mode de réalisation, un substrat de type silicium sur isolant est d'abord fourni (figures 6A, 6B). De façon connue, un tel substrat comprend typiquement une couche 12 mince de silicium, également appelée topSi, sur une couche 11 d'oxyde enterré dite BOX, le tout étant sur un substrat 10 de silicium massif dit bulk. Selon une variante, le topSi peut être remplacé par une couche 12 mince en SiGe. Le topSi 12 présente typiquement ici une épaisseur e comprise entre 5nm et 15nm, par exemple de 6 nm à 8 nm.

Comme illustré aux figures 7A, 7B, une première zone 1 d'enrichissement et une deuxième zone 2 d'enrichissement sont définies, typiquement par lithographie/gravure d'un masque dur 14 à base de SiN ou de $SiO_2$. La première zone 1 forme ainsi une ouverture au sein du masque dur 14, exposant la surface du topSi 12. La première zone 1 présente une largeur W1 et une longueur L1. La deuxième zone 2 présente une largeur W2 et une longueur L2. Elle comprend typiquement une pluralité d'ouvertures 4 au sein du masque dur 14, exposant des surfaces 122 du topSi 12.

La première zone 1, dite zone de référence, est exempte de motifs de masquage comme dans le cas d'un procédé d'enrichissement standard. Elle est destinée à former une première portion à base de SiGe présentant une concentration de Ge [Ge]1. La deuxième zone 2, dite zone modifiée, est partiellement masquée par un réseau de motifs de masquage 3 alternés avec des ouvertures 4. Cette deuxième zone 2 est destinée à former une deuxième portion à base de SiGe présentant une concentration de Ge [Ge]2. Avantageusement, le réseau de motifs de masquage peut être défini lors de l'étape de lithographie/gravure du masque dur 14. Cela permet d'éviter une étape de définition supplémentaire.

Dans cet exemple, une seule zone modifiée 2 est représentée. Ce cas est facilement généralisable à plusieurs zones modifiées i (i=2... m). La zone de référence et les zones modifiées sont destinées à former, à l'issue du procédé, des zones actives à base de SiGe. De telles zones actives peuvent avantageusement être mises en œuvre pour la formation de transistors, en particulier des transistors à effet de champ de type p (pFET).

Le réseau de motifs de masquage présente des motifs de masquage 3 et des ouvertures 4. Les motifs de masquage 3 peuvent se présenter sous forme de lignes, par exemple parallèles entre elles, comme illustré à la figure 7B, ou sous forme de plots carrés ou rectangulaires, ou sous forme de grille, ou plus généralement, sous toute autre forme permettant de masquer le topSi 12 avec une répartition homogène. Les ouvertures 4 présentent une ou des formes complémentaires à celles des motifs de masquage 3. Les motifs de masquage 3 sont de préférence régulièrement répartis le long d'un réseau.

Par exemple et de façon non limitative, des règles de dimensionnement du réseau de motifs de masquage sont présentées ci-dessous.

Les motifs de masquage 3 présentent typiquement une dimension caractéristique de masquage $Lm_2$ de l'ordre de quelques dizaines de nanomètres. Ils peuvent être espacés les uns des autres par un pas de réseau $Lo_2$ de l'ordre de quelques dizaines de nanomètres également, de préférence supérieur à $Lm_2$. Ce pas correspond à la dimension caractéristique selon x des ouvertures 4 ménagées dans le masque dur 14 au niveau de la deuxième zone 2.

La largeur $W_2$ et la longueur $L_2$ sont grandes devant les dimensions $Lm_2$, $Lo_2$.

En particulier, la longueur L2 peut être de l'ordre de quelques microns à quelques dizaines de microns, par exemple de l'ordre de 5 μm. La dimension caractéristique $Lm_2$ est de préférence supérieure à une dimension critique minimale imposée par la résolution de lithographie. Ainsi, $Lm_2$ est typiquement supérieure ou égale à 15 nm. Pour les mêmes raisons de résolution de lithographie, la période du réseau $Lm_2+Lo_2$ est de préférence supérieure ou égale à 60 nm environ.

Pour des raisons liées à la diffusion en phase solide et expliquées par la suite, la dimension $Lm_2$ est de préférence inférieure à deux fois une distance caractéristique d de diffusion du Ge. Le pas du réseau $Lo_2$ n'est de préférence pas trop grand devant $Lm_2$, pour les mêmes raisons liées à la diffusion. Ainsi, $Lo_2$ est de préférence inférieur à dix fois $Lm_2$, et de préférence inférieur à huit fois $Lm_2$. Cela permet d'obtenir une portion à base de SiGe présentant une homogénéité en concentration de Ge améliorée. $Lo_2$ peut être supérieur à deux fois $Lm_2$.

Le réseau de motifs de masquage 3 présente ainsi une densité d'ouverture D définie comme étant le rapport des surfaces exposées 122 du topSi 12 dans la deuxième zone 2 (correspondant aux ouvertures 4), sur la surface totale S de la deuxième zone 2. Dans le cas illustré à la figure 7B, $S = W_2.L_2$. Les surfaces exposées 122 présentent une surface totale $S' = Lo_2.W_2.(n+1)$, avec n le nombre de lignes 3.

La densité d'ouverture D, strictement comprise entre 0 et 1, $0 < D < 1$, est alors égale à $D = S'/S = (n+1).Lo_2/L_2$. Lorsque n est suffisamment grand, la densité d'ouverture D vaut approximativement : $D \approx Lo_2/(Lm_2+Lo_2)$.

La concentration de Ge [Ge]2 obtenue à l'issue du procédé dépend de cette densité d'ouverture D. En particulier, [Ge]2 = D.[Ge]1.

Ainsi, le réseau de motifs de masquage peut être dimensionné en fonction de la concentration de Ge finale souhaitée. Par exemple, pour une concentration en Ge dans la zone de référence [Ge]1 = 25%, et pour une concentration souhaitée dans la zone 2 [Ge]2 = 20%, on choisira une densité d'ouverture D = [Ge]2/[Ge]1 = 0,8. Pour une longueur L2 = 5 μm, un choix possible des paramètres Lm2, Lo2, n peut être : Lm2 = 25nm, Lo2 = 100nm, n = 41. Pour une longueur L2 = 2 μm, un choix possible des paramètres Lm2, Lo2, n peut être : Lm2 = 25nm, Lo2 = 100nm, n = 17. Ainsi, il est possible d'ajuster uniquement le nombre de motifs en fonction des dimensions de la zone d'enrichissement visée. Cela simplifie le design du réseau de motifs de masquage.

Dans le cas général, pour obtenir une concentration en Ge [Ge]i dans une zone d'enrichissement i présentant une dimension Li, on peut insérer un réseau de motifs de masquage comprenant des lignes de dimension caractéristique Lmi espacées par un pas Loi, tel que: Li=n.Lmi+(n+1).Loi. La densité d'ouverture s'écrit alors

$$D = (n+1).Loi/Li \approx Loi/(Lmi+Loi).$$

Comme illustré aux figures 8A, 8B, après formation du réseau de motifs de masquage, une épitaxie de couches 20, 20' de SiGe est réalisée dans les première et deuxième zones 1, 2 d'enrichissement. Cette épitaxie peut être sélective, c'est-à-dire que les couches 20, 20' croissent uniquement sur les surfaces exposées du top Si dans les première et deuxième zones 1, 2. Selon une possibilité alternative, elle peut être non sélective. Elle est de préférence effectuée de manière à éviter la formation de facettes. Elle est de préférence effectuée de manière à obtenir des couches 20, 20' de SiGe non dopées.

La première zone 1, exempte de motifs de masquage, présente typiquement une densité d'ouverture égale à 1. La surface exposée du topSi 12 dans la première zone 1 est typiquement égale à la surface totale de la première zone 1. Au contraire, dans la deuxième zone 2, la somme S' des surfaces exposées 122 est strictement inférieure à la surface totale S de ladite deuxième zone 2, du fait des motifs de masquage 3. La deuxième zone 2 présente une densité d'ouverture strictement inférieure à la densité d'ouverture de la première zone 1. La deuxième zone d'enrichissement 2, sur laquelle est formé le réseau de motifs de masquage 3, présente une densité D d'ouvertures 4 strictement inférieure à 1, tandis que la première zone d'enrichissement 1, dépourvue de réseau de motifs de masquage 3, présente une densité d'ouvertures dite de référence égale à 1.

La couche 20 de SiGe épitaxiée dans la zone 1 de référence présente de préférence une épaisseur e0 comprise entre 5nm et 30nm, préférentiellement entre 7 nm et 25 nm, et une concentration en Ge [Ge]0 comprise entre 10% et 30%.

Les couches 20' de SiGe épitaxiées dans les ouvertures 4 de la zone 2 peuvent avantageusement présenter les mêmes propriétés que la couche 20. Ainsi, les couches 20' présentent de préférence une épaisseur e0 et une concentration en Ge [Ge]0.

Comme illustré aux figures 9A, 9B, après épitaxie des couches 20, 20' à base de Ge, une première diffusion de Ge depuis les couches 20, 20' vers le topSi 12 est effectuée par recuit oxydant. Les conditions du recuit oxydant sont typiquement une température T1 comprise entre 950°C et 1100°C, pendant un temps t1 compris typiquement entre 5s et 200s. L'interface de diffusion est d'autant meilleure que le recuit oxydant est effectué selon un temps t1 court. Le recuit oxydant peut être du type oxydation thermique rapide RTO (acronyme de Rapid Thermal Oxidation), par exemple à 950°C ou à 1050°C pendant 60s, ou à 1000°C pendant 30s, ou encore à 1100°C pendant 5s typiquement. D'autres couples de valeurs (T1, t1) peuvent être choisis en fonction de l'épaisseur e et de la nature de la couche mince 12 (Si ou SiGe), ou encore du bâti d'oxydation dans lequel est effectué le recuit d'oxydation. Des abaques peuvent être utilisés ou formés pour déterminer les conditions de recuit oxydant optimales. Le recuit oxydant sera notamment plus court et/ou à plus basse température pour une couche mince 12 en SiGe. D'autres recuits oxydants peuvent être envisagés. Les recuits oxydants suivants peuvent notamment être envisagés :

- Un recuit couramment dénommé « dry oxidation » comprenant une rampe thermique sous N2 atmosphérique avec un début de rampe sous O2, suivie d'un recuit sous O2 uniquement, suivi d'une descente thermique sous N2.
- Un recuit couramment dénommé ISSG (acronyme de « in-Situ Steam Generation [Oxidation] ») comprenant une première rampe thermique sous O2, suivi d'une deuxième rampe et d'un recuit sous O2+H2, suivi d'une descente thermique sous O2.

Le recuit oxydant pourra être ajusté en fonction de la concentration de Ge [Ge]0 initiale.

Cette première diffusion se fait principalement selon z. Elle permet d'enrichir localement le topSi 12 en Ge. Une première portion 21 à base de SiGe est ainsi formée au niveau de la zone 1 de référence. Des parties 21' à base de SiGe sont ainsi formées au niveau de la zone 2 modifiée. La première portion 21 présente typiquement une concentration de Ge [Ge]1, et une épaisseur e1. Les parties 21' présentent avantageusement chacune la concentration de Ge [Ge]1, et l'épaisseur e1. L'épaisseur e1 peut être supérieure ou égale à l'épaisseur e0. On choisira de préférence des conditions d'enrichissement permettant de conserver une épaisseur e1 sensiblement identique à l'épaisseur e0. Après diffusion, la portion 21 et les parties 21' sont surmontées par une couche d'oxyde 22.

Selon un exemple, pour une couche mince 12 de silicium d'épaisseur e = 8nm et pour une épaisseur de couches 20, 20' à base de Ge e0 = 8nm, et pour une concentration en Ge des couches 20, 20' [Ge]0 = 27%, la portion 21 et les parties 21' peuvent présenter une épaisseur e1 = 9 nm et une concentration de Ge [Ge]1 = 24%.

Selon un exemple, pour une couche mince 12 de silicium d'épaisseur e = 8nm et pour une épaisseur de couches 20, 20' à base de Ge e0 = 8nm, et pour une concentration en Ge des couches 20, 20' [Ge]0 = 27%, la portion 21 et les parties 21' peuvent présenter une épaisseur e1 = 8 nm et une concentration de Ge [Ge]1 = 27%.

Ainsi, il est possible d'ajuster l'épaisseur e0 et la concentration [Ge]0 en fonction de l'épaisseur e et de la nature de la couche mince 12 (Si ou SiGe), afin d'obtenir une portion 21 et des parties 21' d'épaisseur e1 et de concentration [Ge]1 souhaitées.

Comme illustré aux figures 10A, 10B, après formation de la portion 21 et des parties 21', une deuxième diffusion de Ge depuis lesdites portion et parties 21, 21' vers le topSi 12 est effectuée par un recuit additionnel non oxydant.

Ce recuit non oxydant se fait typiquement sous atmosphère neutre, par exemple sous argon, sous azote ou sous hélium, à une température T2 comprise typiquement entre 950°C et 1150°C, pendant un temps t2 compris entre 5s et 60s. Le recuit non oxydant peut être du type recuit thermique rapide RTA (acronyme de Rapid Thermal Annealing), par exemple à 1100°C pendant 30s. D'autres couples de valeurs (T2, t2) peuvent être choisis en fonction de l'épaisseur e et de la nature de la couche mince 12 (Si ou SiGe). Le recuit non oxydant sera notamment plus court et/ou à plus basse température pour une couche mince 12 en SiGe, par exemple à 1100°C pendant 10s, ou à 1000°C pendant 30s. Selon une possibilité, le recuit non oxydant est effectué en prolongation du recuit oxydant. Il n'est ainsi pas nécessaire de diminuer la température entre les deux recuits.

Cette deuxième diffusion se fait principalement dans le plan xy, par exemple selon x dans le cas illustré aux figures 10A, 10B. Cette diffusion se fait typiquement sur une distance de diffusion d. La distance de diffusion d peut être comprise entre 10 nm et 25 nm environ, en fonction notamment de la température T2 et du temps t2. Une telle diffusion latérale permet avantageusement d'homogénéiser la concentration de germanium au sein de la couche mince 12 sur toute la zone 2 d'enrichissement. En particulier, le germanium diffuse sous les motifs de masquage, de part et d'autre des parties 21'. Une deuxième portion 21" à base de SiGe est ainsi formée au niveau de la zone 2. Cette deuxième portion 21" présente avantageusement une concentration de Ge [Ge]2 inférieure à la concentration [Ge]1. Cette deuxième portion 21" présente une épaisseur e2 sensiblement égale à l'épaisseur e1.

Le phénomène de diffusion latérale est très limité au niveau de la première portion 21. Celui-ci survient essentiellement en périphérie de la zone 1, sur une distance d faible. À l'issue de la deuxième diffusion, la première portion 21 présente donc une concentration de Ge sensiblement égale à [Ge]1.

Le procédé permet ainsi de former simultanément, lors d'un même module d'enrichissement, une première portion 21 à base de SiGe de concentration [Ge]1 et une deuxième portion 21" à base de SiGe de concentration [Ge]2 inférieure à la concentration [Ge]1.

Comme illustré aux figures 11A, 11B, après formation de la portion 21 et de la portion 21", la couche d'oxyde 22 et le masque dur 14 peuvent être retirés, par exemple par un procédé de gravure humide. Du fait de la diffusion latérale, les première et deuxième zones 1, 2 s'étendent sur une distance d en bordure des zones définies initialement. Ce débordement latéral des portions 21, 21" en SiGe présente typiquement un profil décroissant de concentration en Ge, de [Ge]1, respectivement [Ge]2, à une concentration nulle (ou à la concentration initiale de la couche mince dans le cas d'une couche mince initiale en SiGe) pour les zones masquées situées à une distance supérieure à d des ouvertures.

Comme illustré aux figures 12A, 12B, les différentes zones 1, 2 peuvent ensuite être isolées entre elles par des tranchées d'isolation STI 40 (acronyme de Shallow Trench Isolation). Les tranchées STI 40 peuvent être formées de façon connue par lithographie/gravure, remplissage et densification d'oxyde. La définition des tranchées d'isolation est de préférence telle que les dimensions initiales L1, W1, L2, W2 des zones 1, 2 isolées sont réduites d'une distance 2.dc, où dc est une dimension critique de l'ordre de 15 nm à 20 nm. Cela permet de supprimer les défauts en bords de zones 1, 2, et/ou le débordement latéral de concentration progressivement décroissante en Ge. Cela permet d'obtenir un profil abrupte en bord de zones 1, 2. La distance entre deux zones 1, 2, par exemple la longueur du STI 40 selon x, peut être de l'ordre de 50 nm à 70 nm.

Le procédé peut avantageusement être mis en œuvre pour former des transistors pFET sur les zones actives en SiGe d'un circuit électronique. Ces transistors comprennent typiquement une grille présentant une longueur de grille Lg. Le fonctionnement de ces transistors est notamment caractérisé par une tension de seuil Vth. Pour certaines applications, les transistors pFET ne présentent pas tous la même longueur de grille Lg. La tension de seuil Vth dépend généralement de la longueur de grille Lg. Pour optimiser le fonctionnement global du circuit électronique, il peut être particulièrement intéressant d'avoir sensiblement la même tension de seuil Vth pour tous les transistors pFET, quelles que soient leurs longueurs de grille Lg.

Pour obtenir une tension de seuil Vth sensiblement constante pour différentes longueurs de grille Lg, il est possible d'ajuster la concentration en Ge de chacune des zones actives en SiGe sous-jacentes auxdites grilles. On pourra par exemple utiliser une relation liant la tension de seuil Vth à la concentration en Ge [Ge] du SiGe et à la déformation intrinsèque ε du SiGe, telle que :

$$Vth(x) = Vth0 + Sx * [Ge] + S\varepsilon * \varepsilon([Ge])$$

Où Vth0 est la tension de seuil d'une grille de longueur de grille donnée. Les coefficients **Sx,Sε** peuvent être déterminés par modélisation, par exemple d'après la publication « F. Andrieu et al., « Strain and Layout Management in dual Channel (sSOI substrate, SiGe channel) planar FDSOI MOSFETs », Proc. of ESSDERC conference, pp. 106-109, 2014 ». Selon un exemple, *Sx = 10mV/%* et *Sε = -93,74mV/%.* La déformation intrinsèque ε du SiGe peut également s'exprimer selon :

$$\varepsilon([Ge]) = -0,042 * [Ge]$$

Pour une grille de longueur de grille donnée, il existe donc une relation de proportionnalité entre la tension de seuil Vth et la concentration en Ge [Ge] du SiGe de la zone active sous-jacente à cette grille. Il est ainsi possible d'ajuster la concentration en Ge [Ge] dans des zones actives séparées, de façon à modifier la tension de seuil Vth des grilles présentes sur chacune de ces zones.

Comme illustré aux figures 13A, 13B, le procédé permet avantageusement d'ajuster cette concentration en Ge [Ge] dans différentes zones actives 1a, 2a, 3a. En formant des grilles 51, 52, 53 présentant respectivement des longueurs de grille Lg1, Lg2, Lg3 différentes sur ces zones actives 1a, 2a, 3a présentant des concentrations de Ge [Ge]1, [Ge]2, [Ge]3 différentes, il est possible d'obtenir pour l'ensemble des grilles 51, 52, 53 une tension de seuil Vth sensiblement identique.

En particulier, pour des longueurs de grilles Lg1 < Lg2 < Lg3, on choisira des concentrations [Ge]1 < [Ge]2 < [Ge]3.

Au vu de la description qui précède, il apparaît clairement que le procédé proposé offre une solution particulièrement efficace pour réaliser des zones actives à base de SiGe de mêmes épaisseurs et présentant des concentrations en Ge différentes, lors de la mise en œuvre d'un seul et même module d'enrichissement.

L'invention n'est pas limitée aux modes de réalisations précédemment décrits. Selon une possibilité, la première zone d'enrichissement est également obtenue par diffusion verticale, puis latérale sous des motifs de masquage. Elle présente la concentration [Ge]1 en germanium. Dans ce cas la deuxième zone d'enrichissement est formée à partir d'un réseau de motifs de masquage plus dense que dans la première zone d'enrichissement. La densité d'ouverture de la deuxième zone est plus faible que la densité d'ouverture de la première zone. Après diffusions verticale et latérale, la deuxième zone présente ainsi une concentration [Ge]2 en germanium inférieure à la concentration [Ge]1.

**Revendications**

1. Procédé de formation d'au moins deux zones (21, 21") à base de SiGe dans une couche (12) à base de silicium, comprenant les étapes suivantes :

    - Fournir un substrat comprenant ladite couche (12) à base de silicium,
    - Définir au moins une première zone d'enrichissement (1) en exposant une première portion de la couche (12) à base de silicium,
    - Former par épitaxie une première couche (20) à base de Ge présentant une concentration initiale de Ge [Ge]0 sur la première portion, au niveau de ladite première zone d'enrichissement (1),
    - Faire diffuser lors d'une première diffusion par recuit oxydant, selon une première direction (z) perpendiculaire à la première couche (20) à base de Ge, le germanium de la première couche (20) à base de Ge dans la première portion correspondant à la première zone d'enrichissement (1), ladite première portion devenant alors une première portion (21) à base de SiGe présentant une première concentration de Ge [Ge] 1, et la première couche (20) à base de Ge devenant alors une première couche (22) d'oxyde,

le procédé comprenant en outre les étapes suivantes:

    - Définir au moins une deuxième zone d'enrichissement (2) où la couche (12) à base de silicium est exposée, ladite au moins une deuxième zone d'enrichissement (2) étant distincte de la première zone d'enrichissement (1),
    - Former un réseau de motifs de masquage (3) sur la couche (12) à base de silicium exposée au sein de l'au moins une deuxième zone d'enrichissement (2), de façon à définir une pluralité de portions transitoires de la couche (12) à base de silicium,
    - Former par épitaxie une deuxième couche (20') à base de Ge présentant la concentration initiale de Ge [Ge]0 sur les portions transitoires de la couche (12) à base de silicium, au niveau de ladite deuxième zone d'enrichissement (2),
    - Faire diffuser par recuit oxydant, selon la première direction (z), le germanium de la deuxième couche (20') à base de Ge dans lesdites portions transitoires, de sorte que celles-ci deviennent des portions transitoires (21') à base de SiGe présentant chacune la première concentration de Ge [Ge]1,
    - Après diffusion du germanium par recuit oxydant selon la première direction (z), faire diffuser lors d'une deuxième diffusion, selon une deuxième direction (x) parallèle à la couche (12) à base de silicium, le germanium desdites portions transitoires (21') à base de SiGe au sein de la couche (12) à base de silicium, sous le réseau de motifs de masquage (3), de façon à former au moins une deuxième portion (21") à base de SiGe présentant une deuxième concentration de Ge [Ge]2 inférieure à [Ge]1, au niveau de la deuxième zone d'enrichissement (2).

2. Procédé selon la revendication précédente dans lequel les première et deuxième portions (21, 21") à base de SiGe sont formées simultanément.

3. Procédé selon l'une quelconque des revendications précédentes dans lequel le réseau de motifs de masquage (3) est formé de sorte à présenter une densité D d'ouvertures (4) strictement comprise entre 0 et 1, 0 < D < 1, et la deuxième concentration de Ge [Ge]2 est proportionnelle à cette densité D d'ouvertures (4) telle que [Ge]2 = D. [Ge]1.

4. Procédé selon l'une quelconque des revendications précédentes dans lequel le réseau de motifs de masquage (3) comprend des motifs de masquage (3) présentant une dimension caractéristique de masquage $Lm_i$ espacés les uns des autres par un pas de réseau $Lo_i$, tels que $10 > Lo_i/Lm_i > 2$.

5. Procédé selon la revendication précédente dans lequel la dimension caractéristique de masquage $Lm_i$ est choisie inférieure à deux fois une distance de diffusion d du germanium au sein de la couche (12) à base de silicium selon la deuxième direction (x), lors de la deuxième diffusion.

6. Procédé selon l'une quelconque des deux revendications précédentes dans lequel les motifs de masquage (3) se présentent sous forme de lignes parallèles entre elles, ou de plots carrés ou rectangulaires ou de grille.

7. Procédé selon l'une quelconque des revendications précédentes dans lequel les première et deuxième couches (20, 20') à base de Ge sont formées par une seule et même épitaxie, de sorte que les première et deuxième couches (20, 20') à base de Ge présentent la même concentration initiale de Ge [Ge]0 et une même épaisseur.

8. Procédé selon l'une quelconque des revendications précédentes dans lequel la deuxième diffusion se fait sous atmosphère neutre ou non oxydante.

9. Procédé selon l'une quelconque des revendications précédentes dans lequel la deuxième diffusion est paramétrée en temps et en température de sorte qu'une distance de diffusion d du germanium selon la deuxième direction (x) soit comprise entre 10 nm et 30 nm.

10. Procédé selon l'une quelconque des revendications précédentes dans lequel la deuxième diffusion est effectuée à une température T2 comprise entre 950°C et 1150°C, pendant un temps t2 compris entre 5s et 60s.

11. Procédé selon l'une quelconque des revendications précédentes dans lequel la deuxième diffusion est effectuée dans des conditions similaires à celles de la première diffusion, de sorte que la deuxième diffusion forme un prolongement de la première diffusion.

12. Procédé selon l'une quelconque des revendications précédentes comprenant en outre la formation de première et deuxième grilles (51, 52) respectivement sur les première et deuxième portions (21, 21") à base de SiGe, lesdites première et deuxième grilles (51, 52) présentant respectivement des première et deuxième longueurs de grille Lg1 et Lg2, les première et deuxième concentrations de Ge [Ge]1 et [Ge]2 et les longueurs de grille Lg1 et Lg2 étant telles que les première et deuxième grilles (51, 52) présentent une tension de seuil Vth identique.

13. Dispositif électronique comprenant un substrat comprenant une couche (12) à base de silicium, ladite couche (12) à base de silicium comprenant au moins une première portion (21) à base de SiGe présentant une première concentration de Ge [Ge]1, et au moins une deuxième portion (21") à base de SiGe présentant une deuxième concentration de Ge [Ge]2 inférieure à [Ge]1, lesdites première et deuxième portions (21, 21") étant issues du procédé de formation selon la revendication 1, ledit dispositif comprenant en outre des première et deuxième grilles (51, 52) respectivement sur les première et deuxième portions (21, 21") à base de SiGe, lesdites première et deuxième grilles (51, 52) présentant respectivement des première et deuxième longueurs de grille Lg1 et Lg2, les première et deuxième concentrations de Ge [Ge]1 et [Ge]2 et les longueurs de grille Lg1 et Lg2 étant telles que les première et deuxième grilles (51, 52) présentent une tension de seuil Vth identique.

**Patentansprüche**

1. Verfahren zur Bildung von mindestens zwei Bereichen (21, 21") auf SiGe-Basis in einer Schicht (12) auf Silizium-Basis, umfassend die folgenden Schritte:

    - Bereitstellen eines Substrats, das die Schicht (12) auf Silizium-Basis umfasst,
- Festlegen mindestens eines ersten Anreicherungsbereichs (1) durch Freilegen eines ersten Abschnitts der Schicht (12) auf Silizium-Basis,
- Bilden durch Epitaxie einer ersten Schicht (20) auf Ge-Basis, die eine Anfangskonzentration von Ge [Ge]0 auf dem ersten Abschnitt auf Höhe des ersten Anreicherungsbereichs (1) aufweist,
- Diffundieren lassen bei einer ersten Diffusion durch Oxidationsglühen, entlang einer ersten Richtung (z) senkrecht zu der ersten Schicht (20) auf Ge-Basis, des Germaniums der ersten Schicht (20) auf Ge-Basis in den ersten Abschnitt, der dem ersten Anreicherungsbereich (1) entspricht, wobei der erste Abschnitt daraufhin zu einem ersten Abschnitt (21) auf SiGe-Basis mit einer ersten Konzentration von Ge [Ge]1 wird, und die erste Schicht (20) auf Ge-Basis daraufhin zu einer ersten Oxidschicht (22) wird,

wobei das Verfahren ferner die folgenden Schritte umfasst:

- Festlegen mindestens eines zweiten Anreicherungsbereichs (2), in dem die Schicht (12) auf Silizium-Basis freigelegt ist, wobei sich der mindestens zweite Anreicherungsbereich (2) von dem ersten Anreicherungsbereich (1) unterscheidet,
- Bilden eines Netzes aus Maskierungsmustern (3) auf der freiliegenden Schicht (12) auf Silizium-Basis innerhalb des mindestens zweiten Anreicherungsbereichs (2), um eine Vielzahl von Übergangsabschnitten der Schicht (12) auf Silizium-Basis festzulegen,
- Bilden durch Epitaxie einer zweiten Schicht (20') auf Ge-Basis mit der ursprünglichen Konzentration von Ge [Ge]0 auf den Übergangsabschnitten der Schicht (12) auf Silizium-Basis auf Höhe des zweiten Anreicherungsbereichs (2),
- Diffundieren lassen durch Oxidationsglühen, entlang der ersten Richtung (z), des Germaniums der zweiten Schicht (20') auf Ge-Basis in die Übergangsabschnitte, so dass diese Übergangsabschnitte (21') auf SiGe-Basis werden, die jeweils die erste Konzentration von Ge [Ge]1 aufweisen,
- Nach Diffusion des Germaniums durch Oxidationsglühen entlang der ersten Richtung (z), Diffundieren lassen bei einer zweiten Diffusion, entlang einer zweiten Richtung (x) parallel zu der Schicht (12) auf Silizium-Basis des Germaniums der Übergangsabschnitte (21') auf SiGe-Basis innerhalb der Schicht (12) auf Silizium-Basis unter dem Netz von Maskierungsmustern (3), so dass mindestens ein zweiter Abschnitt (21") mit einer zweiten Konzentration von Ge [Ge]2, die kleiner als [Ge]1 ist, auf Höhe des zweiten Anreicherungsbereichs (2) gebildet wird.

2.    Verfahren nach dem vorhergehenden Anspruch, wobei die ersten und zweiten Abschnitte (21, 21") auf SiGe-Basis gleichzeitig gebildet werden.

3.    Verfahren nach einem der vorhergehenden Ansprüche, wobei das Netz aus Maskierungsmustern (3) so gebildet ist, dass es eine Dichte D von Öffnungen (4) aufweist, die streng zwischen 0 und 1, 0 < D < 1, liegt, und die zweite Konzentration von Ge [Ge]2 proportional zu dieser Dichte D von Öffnungen (4) ist, sodass [Ge]2 = D. [Ge]1.

4.    Verfahren nach einem der vorhergehenden Ansprüche, wobei das Netz aus Maskierungsmustern (3) Maskierungsmuster (3) umfasst, die eine charakteristische Maskierungsabmessung $Lm_i$ aufweisen, die voneinander durch einen Netzschritt $Lo_i$ wie 10 > $Lo_i/Lm_i$ > 2 beabstandet sind.

5.    Verfahren nach dem vorhergehenden Anspruch, wobei die charakteristische Maskierungsabmessung $Lm_i$ kleiner als das Doppelte eines Diffusionsabstands d des Germaniums innerhalb der Schicht (12) auf Silizium-Basis entlang der zweiten Richtung (x), bei der zweiten Diffusion, gewählt wird.

6.    Verfahren nach einem der beiden vorhergehenden Ansprüche, wobei die Maskierungsmuster (3) in Form von parallel zueinander verlaufenden Linien oder quadratischen oder rechteckigen Stiften oder Gittern vorliegen.

7.    Verfahren nach einem der vorhergehenden Ansprüche, wobei die erste und zweite Schicht (20, 20') auf Ge-Basis durch ein und dieselbe Epitaxie gebildet werden, so dass die erste und zweite Schicht (20, 20') auf Ge-Basis dieselbe Anfangskonzentration von Ge [Ge]0 und dieselbe Dicke aufweisen.

8.    Verfahren nach einem der vorhergehenden Ansprüche, wobei die zweite Diffusion unter neutraler oder nicht oxidierender Atmosphäre erfolgt.

9.    Verfahren nach einem der vorhergehenden Ansprüche, wobei die zweite Diffusion in Zeit und Temperatur so eingestellt ist, dass eine Diffusionsdistanz d des Germaniums entlang der zweiten Richtung (x) zwischen 10 nm und 30 nm liegt.

10.   Verfahren nach einem der vorhergehenden Ansprüche, wobei die zweite Diffusion bei einer Temperatur T2 zwischen 950 °C und 1150 °C für eine Zeit 12 zwischen 5s und 60s durchgeführt wird.

**11.** Verfahren nach einem der vorhergehenden Ansprüche, wobei die zweite Diffusion unter Bedingungen durchgeführt wird, die denen der ersten Diffusion ähnlich sind, so dass die zweite Diffusion eine Fortsetzung der ersten Diffusion bildet.

**12.** Verfahren nach einem der vorhergehenden Ansprüche, das ferner die Bildung von ersten und zweiten Gittern (51, 52) auf den ersten und zweiten Abschnitten (21, 21") auf SiGe-Basis umfasst, wobei die ersten und zweiten Gitter (51, 52) jeweils erste und zweite Gitterlängen Lg1 und Lg2 aufweisen, wobei die ersten und zweiten Konzentrationen von Ge [Ge]1 und [Ge]2 und die Gitterlängen Lg1 und Lg2 so sind, dass die ersten und zweiten Gitter (51, 52) eine identische Schwellenspannung Vth aufweisen.

**13.** Elektronische Vorrichtung, die ein Substrat umfasst, das eine Schicht (12) auf Silizium-Basis umfasst, wobei die Schicht (12) auf Silizium-Basis mindestens einen ersten Abschnitt (21) auf SiGe-Basis mit einer ersten Konzentration von Ge [Ge]1 und mindestens einen zweiten Abschnitt (21") auf SiGe-Basis mit einer zweiten Konzentration von Ge [Ge]2, die kleiner als [Ge]1 ist, umfasst, wobei der erste und zweite Abschnitt (21, 21") aus dem Bildungsverfahren nach Anspruch 1 stammen, wobei die Vorrichtung ferner erste und zweite Gitter (51, 52) an den ersten und zweiten Abschnitten (21, 21") auf SiGe-Basis umfasst, wobei das erste und das zweite Gitter (51, 52) jeweils eine erste und eine zweite Gitterlänge Lg1 und Lg2 aufweisen, wobei die erste und die zweite Ge-Konzentration [Ge]1 und [Ge]2 und die Gitterlängen Lg1 und Lg2 so sind, dass das erste und das zweite Gitter (51, 52) eine identische Schwellenspannung Vth aufweisen.

**Claims**

**1.** A method for forming at least two SiGe-based regions (21, 21") in a silicon-based layer (12), comprising the following steps:

- Providing a substrate comprising said silicon-based layer (12),
- Defining at least a first enrichment region (1) by exposing a first portion of the silicon-based layer (12),
- Forming, by epitaxial growth, a first Ge-based layer (20) having an initial Ge concentration [Ge]0 on the first portion, at said first enrichment region (1),
- Diffusing during a first diffusion by oxygen annealing, in a first direction (z) perpendicular to the first Ge-based layer (20), the germanium of the first Ge-based layer (20) in the first portion corresponding to the first enrichment region (1), said first portion then becoming a first SiGe-based portion (21) having a first Ge concentration [Ge]1, and the first Ge-based layer (20) then becoming a first oxide layer (22),

the method further comprising the following steps:

- Defining at least a second enrichment region (2) where the silicon-based layer (12) is exposed, said at least one second enrichment region (2) being separate from the first enrichment zone (1),
- Forming a grating of masking patterns (3) on the exposed silicon-based layer (12) within the at least one second enrichment region (2), so as to define a plurality of transient portions of the silicon-based layer (12),
- Forming, by epitaxial growth, a second Ge-based layer (20'), having the initial Ge concentration [Ge]0 on the transient portions of the silicon-based layer (12), at said second enrichment region (2),
- Diffusing, by oxygen annealing, in the first direction (z), the germanium of the second Ge-based layer (20') into said transient portions, such that these become SiGe-based transient portions (21'), each having the first Ge concentration [Ge]1,
- After the diffusion of germanium by oxygen annealing in the first direction (z), diffusing, during a second diffusion, in a second direction (x) parallel to the silicon-based layer (12), the germanium of said SiGe-based transient portions (21') within the silicon-based layer (12), beneath the grating of masking patterns (3), so as to form at least a second SiGe-based portion (21") having a second Ge concentration [Ge]2 that is lower than [Ge]1, at the second enrichment region (2).

**2.** The method according to the preceding claim, wherein the first and second SiGe-based portions (21, 21") are formed simultaneously.

**3.** The method according to any one of the preceding claims, wherein the grating of masking patterns (3) is formed so as to have an aperture (4) density (D) strictly between 0 and 1, $0 < D < 1$, and the second Ge concentration [Ge]2 is proportional to this aperture (4) density D such that $[Ge]2 = D \cdot [Ge]1$.

**4.** The method according to any one of the preceding claims, wherein the grating of masking patterns (3) comprises masking patterns (3) having a characteristic masking dimension $Lm_i$ spaced apart from one another by a grating period $Lo_i$ such that $10 > Lo_i/Lm_i > 2$.

**5.** The method according to the preceding claim, wherein the characteristic masking dimension $Lm_i$ is selected such that it is less than twice a diffusion distance d of the germanium within the silicon-based layer (12) in the second direction (x), during the second diffusion.

**6.** The method according to any one of the preceding two claims, wherein the masking patterns (3) are in the form of parallel lines, square or rectangular pads, or a gate.

**7.** The method according to any one of the preceding claims, wherein the first and second Ge-based layers (20, 20') are formed by one and the same epitaxial growth, such that the first and second Ge-based layers (20, 20') have the same initial Ge concentration [Ge]0 and the same thickness.

**8.** The method according to any one of the preceding claims, wherein the second diffusion takes place in a neutral or non-oxidising atmosphere.

**9.** The method according to any one of the preceding claims, wherein the second diffusion is configured in terms of time and temperature such that a diffusion distance d of the germanium in the second direction (x) is comprised between 10 nm and 30 nm.

**10.** The method according to any one of the preceding claims, wherein the second diffusion is carried out at a temperature T2 comprised between 950°C and 1,150°C, for a time t2 ranging comprised between 5s and 60s.

**11.** The method according to any one of the preceding claims, wherein the second diffusion is carried out under similar conditions to those of the first diffusion, such that the second diffusion forms a continuation of the first diffusion.

**12.** The method according to any one of the preceding claims, further comprising forming first and second gates (51, 52) on the first and second SiGe-based portions (21, 21") respectively, said first and second gates (51, 52) having first and second gate lengths Lg1 and Lg2 respectively, the first and second Ge concentrations [Ge]1 and [Ge]2 and the gate lengths Lg1 and Lg2 being such that the first and second gates (51, 52) have an identical threshold voltage Vth.

**13.** An electronic device comprising a substrate comprising a silicon-based layer (12), said silicon-based layer (12) comprising at least a first SiGe-based portion (21) having a first Ge concentration [Ge]1, and at least a second SiGe-based portion (21") having a second Ge concentration [Ge]2 that is lower than [Ge]1, said first and second portions (21, 21") originating from the formation method according to claim 1, said device further comprising first and second gates (51, 52) on the first and second SIGe-based portions (21, 21") respectively, said first and second gates (51, 52) having respective first and second gate lengths Lg1 and Lg2 respectively, the first and second Ge concentrations [Ge]1 and [Ge]2 and the gate lengths Lg1 and Lg2 being such that the first and second gates (51, 52) have an identical threshold voltage Vth.

FIG. 1

FIG. 2

FIG. 3

14

22

13

21

12

11

10

z

y ⊗ → x

FIG. 4

12

21

11

10

z

y ⊗ → x

FIG. 5

FIG. 6A

COUPE A-A

FIG. 6B

FIG. 7A

COUPE B-B

FIG. 7B

FIG. 8A

COUPE C-C

FIG. 8B

FIG. 9A

COUPE D-D

FIG. 9B

FIG. 10A

COUPE E-E

FIG. 10B

FIG. 11A

COUPE F-F

FIG. 11B

FIG. 12A

COUPE G-G

FIG. 12B

FIG. 13A

FIG. 13B

## RÉFÉRENCES CITÉES DANS LA DESCRIPTION

**Documents brevets cités dans la description**

- US 20140349460 A1

- EP 3503175 A1

**Littérature non-brevet citée dans la description**

- **F. ANDRIEU et al.** Strain and Layout Management in dual Channel (sSOI substrate, SiGe channel) planar FDSOI MOSFETs. *Proc. of ESSDERC conference*, 2014, 106-109